# EUROPÄISCHE PATENTSCHRIFT

(11) **EP 1 119 766 B1**
(45) Veröffentlichungstag und Bekanntmachung des Hinweises auf die Patenterteilung: **14.04.2004**
(21) Anmeldenummer: 99950634.8
(22) Anmeldetag: 05.10.1999
(51) Int. Cl.: G01N 27/72

(54) **PRÜFVORRICHTUNG ZUR ERFASSUNG UND LOKALISIERUNG VON MATERIALINHOMOGENITÄTEN**
TESTING DEVICE FOR DETECTING AND DETERMINING MATERIAL INHOMOGENEITIES
DISPOSITIF D'ESSAI POUR DETECTER ET LOCALISER DES HETEROGENEITES DE MATERIAU

(30) Priorität: 06.10.1998 DE 19846025
(43) Veröffentlichungstag der Anmeldung: 01.08.2001
(73) Patentinhaber: Hinken, Johann H., 39114 Magdeburg (DE)
(72) Erfinder: HINKEN, Johann, H., D-31139 Hildesheim (DE); TAVRIN, Yury, D-31162 Bad Salzdetfurth (DE)
(74) Vertreter: Becker Kurig Straus
(86) Internationale Anmeldenummer: PCT/EP1999/007440
(87) Internationale Veröffentlichungsnummer: WO 2000/020856

(56) Entgegenhaltungen:
- EP-A- 0 135 204
- US-A- 4 534 405
- US-A- 5 537 037

## Beschreibung

Die Erfindung betrifft eine Prüfvorrichtung zur Erfassung und Lokalisierung von Materialinhomogenitäten in elektrisch leitenden Werkstücken bzw. Proben.

Gemäß dem Stand der Technik wird bei der Prüfung auf ferromagnetische Einschlüsse das Werkstück vormagnetisiert und anschließend mit einem Magnetfeldmeßgerät abgetastet, wie von J. Tavrin und von J. Hinken auf der "7. Europäischen Konferenz für zerstörungsfreies Testen" in Kopenhagen 1998 und in der Druckschrift des Instituts Dr. Forster 04/95 veröffentlicht. Über die Abtastung in mindestens zwei Ebenen kann auf die Tiefenlage der Einschlüsse geschlossen werden. Bei der Prüfung auf nicht-ferromagnetische Einschlüsse oder Inhomogenitäten wird das Werkstück in ein externes Magnetfeld gebracht, wobei dieses auch das natürlich vorhandene Erdfeld sein kann. Aufgrund von Suszeptibilitätsschwankungen im Werkstück ist das Magnetfeld außerhalb des Werkstücks ortsabhängig. Die Messung mit einem Magnetometer läßt Rückschlüsse auf die nicht-ferromagnetischen Inhomogenitäten zu, wie aus der Veröffentlichung von J. P. Wikswo in der IEEE Trans. Appl. Supercond., Volume 3, Nr. 1 vom März 1993 bekannt. Beide Meßverfahren verwenden keine gezielte Temperaturänderung des Werkstücks.

Thermoelektrische Effekte werden bislang nur zur Sortierung ähnlicher Materialien angewandt, nicht zur Detektion und Lokalisierung von Inhomogenitäten, wie aus einer Veröffentlichung von McMaster in "Non-destructive Testing Handbook", Second Edition, Volume 4, Electromagnetic Testing der American Society for Non-destructive Testing von 1996 und einer Veröffentlichung von A.S. Karolik und A.A. Lukhvich in Sov. J. Nondestruct. Test., Volume 26, Nr. 10 vom Oktober 1990 bekannt. Darüber hinaus ist dazu eine elektrische und mechanische Kontaktierung des Bauteils notwendig.

Die gemäß dem Stand der Technik beschriebenen Geräte zur Magnetfeldmessung, d.h. basierend auf der Remanenz und der Suszeptibilität, haben den Nachteil, daß die Meßsignale nicht stark genug sind, um auch kleine und weit unter der Oberfläche liegende Inhomogenitäten festzustellen und zu quantifizieren. Meßgeräte mit thermoelektrischen Effekten werden zur Detektion und Lokalisierung von Inhomogenitäten noch nicht verwendet.

US-A-4 534 405 offenbart eine Prüfvorrichtung zur Erfassung und Lokalisierung von Materialinhomogenitäten in elektrisch leitenden Proben , aufweisend einen Halter für die zu prüfende Probe , eine Temperatureinstellrichtung zur Ausbildung eines Temperaturprofils in der Probe und zumindest einen Messwertaufnehmer zur kontaktlosen Messung des Magnetfelds ausserhalb der Probe.

In US-A-4 534 405 wird eine oberhalb der Curie-Temperatur geheizten Stahlprobe nur an der Oberfläche auf eine Temperatur unterhalb der Curie-Temperatur abgekühlt und mittels einer Magnetfeldmessung die abgekühlte Oberflächenschicht auf Inhomogenitäten untersucht, während der Kern der Probe eine Temperatur oberhalb der Curie-Temperatur beibehält. Mit dieser bekannten Methode wurde die Aufgabe gelöst die weiteren thermischen Behandlungen der Probe energiesparend durchführen zu können.

Der Erfindung liegt die Aufgabe zugrunde, bei magnetfeldgestützter zerstörungsfreier Prüfung von elektrisch leitenden Werkstücken die Magnetfeldsignale zu vergrößern und damit die Meßauflösung zu erhöhen. Dies gilt sowohl für oberflächennahe Inhomogenitäten wie auch für solche, die tief unter der Oberfläche liegen.

Diese Aufgabe wird vorrichtungstechnisch durch die Merkmale des Anspruchs 1 und verfahrenstechnisch durch die Merkmale des Anspruchs 6 gelöst.

Aufgrund des mittels der Temperatureinstelleinrichtung in einer Probe eingestellten Temperaturprofils werden die Magnetfeldsignale des Materials der Probe, insbesondere von Seigerungen, derart verstärkt, daß Materialinhomogenitäten erfaßt und lokalisiert werden können, wenn das Magnetfeld außerhalb der Probe während einer Positionsänderung gemessen wird. Dadurch können Materialinhomogenitäten an der Oberfläche und auch tief unter der Oberfläche der Probe zerstörungsfrei und exakt erfaßt werden.

Die erfindungsgemäße Prüfvorrichtung mißt und prüft zerstörungsfrei, wobei die Vorrichtung die Temperatur bzw. den Temperaturgradienten im Meßobjekt gezielt einstellt und das Magnetfeld außerhalb des Meßobjekts mißt. Charakteristische Magnetfeldsignaturen kommen aufgrund unterschiedlicher physikalischer Effekte zustande. Zu diesen gehören die Temperaturabhängigkeit der Suszeptibilität, thermoelektrische Effekte und thermomagnetische Effekte.

Meßsignale, die auf Suszeptibilitätsunterschieden basieren, werden stärker, wenn dieser Unterschied größer ist. Nun wird die Suszeptibilität von vielen Materialien mit abnehmender Temperatur größer. Sie ist häufig etwa proportional zum Kehrwert der absoluten Temperatur. Ein Abkühlen des Werkstücks erhöht daher die Suszeptibilität von Grundmaterial und Einschluß und damit auch die Differenz von beiden, wie aus der Veröffentlichung von W. Schultz, "Dielektrische und magnetische Eigenschaften der Werkstoffe", Vieweg, Braunschweig von 1970 bekannt ist. Die Abkühlung ist dabei kontrastverstärkend. Dieses auf Suszeptibilitätsunterschieden basierende Meßverfahren erlaubt, auch tief unter der Oberfläche liegende Inhomogenitäten zu detektieren.

Von den thermoelektrischen Effekten werden in diesem Zusammenhang unter anderem der Seebeck-Effekt und der erste Benedicks-Effekt genutzt, welche aus der Veröffentlichung von Joachim Schubert:"Physikalisch Effekte", Physik-Verlag, Weinheim 1984 bekannt sind.

Wenn zwei Kontaktstellen zwischen zwei unterschiedlichen Materialien auf unterschiedlicher Temperatur liegen, entsteht zwischen Ihnen eine elektrische Spannung. Dies ist eine Thermospannung, der Effekt ist der Seebeck-Effekt. In dem zu prüfenden Bauteil werden diese Kontaktstellen durch die Grenzschicht zwischen Grundmaterial und Einschluß gebildet. Wenn ein Temperaturgradient über dem Einschluß liegt, ist die Voraussetzung für die Entstehung von Thermospannungen und Thermoströmen gegeben. Diese Ströme wiederum erzeugen auch außerhalb des Prüfobjekts ein Magnetfeld, das es mit dem Magnetfeldmeßgerät zu detektieren gilt. Der angesprochene Temperaturgradient kann durch Kühlen oder Erwärmen hergestellt werden. Das Vorzeichen des erzeugten Magnetfeldes gibt zusammen mit dem Vorzeichen des Temperaturgradienten Hinweise auf die Materialklasse der Einschlüsse. Die hierbei zu detektierenden Einschlüsse müssen elektrisch leitend sein.

Risse oder isolierende Einschlüsse in ansonsten homogenem Material können über den ersten Benedicks-Effekt detektiert werden. Nach dem Benedicks-Effekt entsteht in einem homogenen Leiter eine Thermospannung, wenn ein hohes Temperaturgefälle vorliegt. Diese Thermospannung wiederum hat Thermoströme zur Folge, deren Verteilung durch Risse und isolierende Einschlüsse gestört wird. Entsprechende Änderungen im Magnetfeld, das durch diese Ströme außerhalb des Prüfobjekts erzeugt wird, können detektiert werden.

Gemäß der Erfindung werden die thermoelektrischen Effekte beobachtet, ohne einen elektrischen und mechanischen Kontakt herzustellen. Dies hat die Vorteile, daß Fehler durch unreproduzierbare Kontakte vermieden werden, daß das Bauteil mit mehr Freiheitsgraden abgetastet werden kann, und daß dabei keine Kratzspuren hinterlassen werden. Dieses auf thermoelektrischen Effekten basierende Meßverfahren erlaubt, auch tief unter der Oberfläche liegende Inhomogenitäten zu detektieren.

Weitere vorteilhafte Ausgestaltungen der Erfindung sind Gegenstand der Unteransprüche.

Bei Nutzung der thermoelektrischen Effekte kann das Temperaturgefälle in nacheinanderfolgenden Messungen gezielt unterschiedlich eingestellt werden. Die daraus resultierenden unterschiedlichen Meßsignale geben weitere Informationen zur untersuchten Inhomogenität, wie z.B. eine verbesserte Lokalisierung und Formbestimmung.

Weitere Einzelheiten, Merkmale und Vorteile der Erfindung ergeben sich aus der nachfolgenden Beschreibung einer vorteilhaften Ausführungsform der Erfindung anhand der Zeichnungen.

Es zeigen:
- Fig. 1: eine schematische Darstellung der Prüfvorrichtung gemäß der Erfindung;
- Fig. 2: eine graphische Darstellung eines Meßsignals einer Probe, welches von der Prüfvorrichtung von Fig. 1 ermittelt wurde; und
- Fig. 3: eine graphische Darstellung eines weiteren Meßsignals einer Probe, welches von der Prüfvorrichtung von Fig. 1 ermittelt wurde.

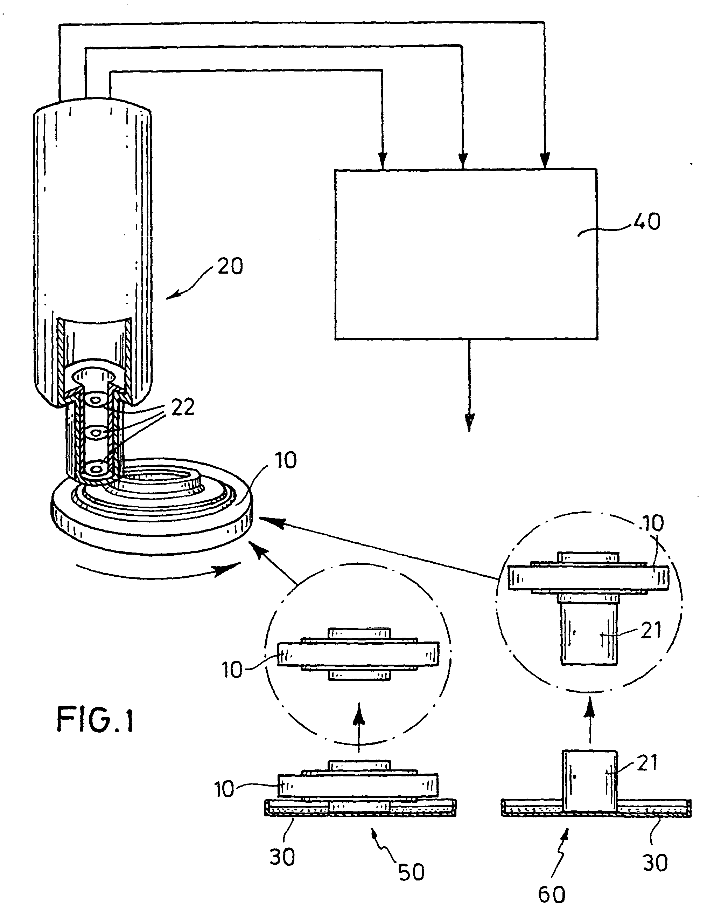

In Fig. 1 ist ein vorteilhaftes Ausführungsbeispiel einer Prüfvorrichtung zur Erfassung und Lokalisierung von Materialinhomogenitäten in einem Meßobjekt bzw. einer Probe 10 gezeigt, welche insbesondere vormagnetisiert ist. Die Probe 10 ist eine kreisförmige Scheibe, die von einem kurzen Rohrstück 21 getragen wird, welches als Abstandshalter und Kältebrücke dient. Die Unterseite des Rohres 21 ist mit Kühlflüssigkeit, insbesondere flüssigem Stickstoff, gekühlt. In der Probe 10 selbst entsteht so ein Temperaturgradient, d.h. ein Temperaturgefälle, bei dem oben eine höhere und unten eine tiefere Temperatur vorliegt. Die Probe 10 wird gedreht und an seiner Oberseite wird das Magnetfeld mit einem Magnetfeldmeßgerät bzw. einem Gradiometer 20 abgetastet. Als Magnetfeldmeßgerät wird ein Squid-Gradiometer 20 zweiter Ordnung (HMT) verwendet, wie in Fig. 1 gezeigt, welches die Normal-Komponente des Magnetfelds an der Oberfläche des Werkstücks bzw. der Probe 10 mißt. Dieses Magnetfeldmeßgerät 20 besteht aus drei einzelnen Squid-Sensoren 22, welche aus Hochtemperatursupraleitem hergestellt sind. Zum Betrieb werden sie mit flüssigem Stickstoff gefüllt. Die drei Sensoren 22 und ihre elektronischen Kanäle sind mechanisch und elektronisch derart abgestimmt, daß Hintergrundfelder extrem unterdrückt werden. Nur Signale aus der benachbarten Probe 10 werden zur Anzeige gebracht, und zwar mit besonders hoher Empfindlichkeit. Dieses Meßsystem benötigt also keine magnetische Abschirmung um die Probe 10 und Sensoren 22 herum, wie sonst bei Squid-Meßsystemen häufig notwendig.

Es gibt unterschiedliche Kühlmethoden, wie in Fig. 1 gezeigt, welche auf der Verwendung einer Kühlflüssigkeit basieren. Bei Verwendung einer ersten Methode 50 wird die Probe 10 großflächig auf der Unterseite eingekühlt, und es stellt sich ein bestimmtes Temperaturgefälle in der Probe 10 ein. Gemäß einer zweiten Methode 60 wird ein Rohrstück 21 eingekühlt, dessen Durchmesser geeignet gewählt und variiert werden kann. Mit Variation des Temperaturgefälles können vorhandene Inhomogenitäten lokalisiert werden. Die Probe 10 kann durch Umdrehen von beiden Seiten vermessen werden. Meist wird dabei ein Polaritätswechsel und eine Amplitudenänderung des Meßsiganls erwartet. Der Gradiometer 20 bzw. der Kryostat mit Gradiometer, insbesonder mit "epoxy dewar" bzw. Epoxy-Pol, weist eine Höhe von ca. 800 mm auf, wobei der Durchmesser des unteren Teils ca. 90 mm beträgt. Das Gradiometer 20 kann in seiner Höhe über der Probe 10 variiert werden, um in einer nacheinander folgenden Messungen die Tiefe einer Inhomongenität zu bestimmen.

Die drei Squid-Sensoren 22 sind normalerweise wie oben beschrieben zu einem Gradiometer 20 zweiter Ordnung elektronisch verschaltet. In Fig. 1 sind die drei Squid-Sensoren 22 mit einer elektronischen Vorrichtung 40 verbunden, wobei die elektronische Vorrichtung 40 ein Meßergebnis in ((d² Bz)/(dz²)) (t) angibt, wie durch den von der elektronischen Vorrichtung 40 wegführenden Pfeil angedeutet. Diese Verschaltung kann leicht geändert werden, so daß die unteren beiden und auch die oberen beiden Squid-Sensoren 22 jeweils zu Gradiometem erster Ordnung verbunden werden können. Auf diese Weise ist es möglich, mit diesen beiden Magnetfeldmeßgeräten gleichzeitig in unterschiedlichen Entfernungen zur Probe 10 zu messen und darüber hinaus eine Tiefenbestimmung vorhandender Inhomogenitäten durchzuführen.

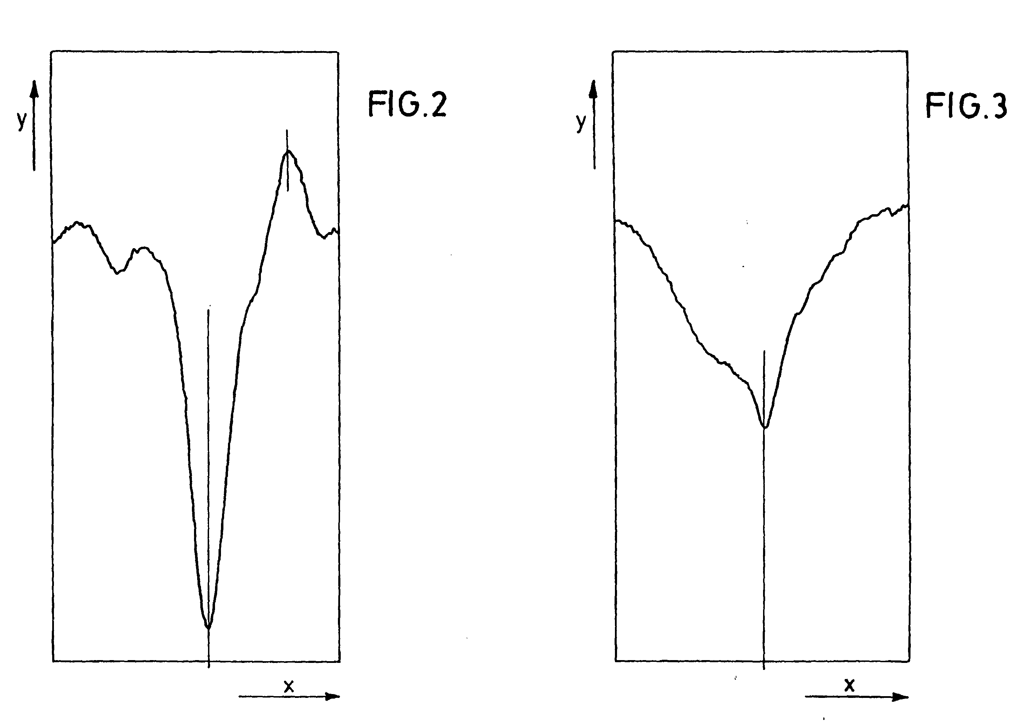

Die Fig. 2 und 3 zeigen graphische Darstellungen von Meßsignalen, welche mit einer Prüfvorrichtung von Fig. 1 aufgenommen wurden, wobei die Scheibe aus der Nickelbasislegierung Waspaloy mit einem Scheibendurchmesser von ca. 180 mm und einer Scheibendicke von ca. 40 mm bestand. In den Fig. 2 und 3 gibt die x-Achse den Drehwinkel der Probe 10 zwischen 0° und 360° an, wobei die y-Achse die Magnetfeldstärke in (d² Bz)/(dz²) angibt. An der Oberfläche war durch Seigerungsätzen unter dem Winkel φ =190°, welcher das Minimum der Graphen darstellt, eine Hard-α-Seigerung erkannt und lokalisiert wurden.

Fig. 2 zeigt das ausgeprägte Meßsignal an der Stelle der Seigerung, hervorgerufen durch Ströme, die gemäß dem Seebeck-Effekt in der Probe 10 fließen. In Fig. 2 ist der Temperaturgradient sehr stark eingestellt, wodurch das Meßsignal stark ausgeprägt ist.

Unter sonst gleichen Bedingungen zeigt Fig. 3 die Messung bei schwächer eingestellten Temperaturgradienten mit entsprechend weniger stark ausgeprägtem Meßsignal mit dem Minimum des Graphen bei φ =190°.

## Patentansprüche

1. Prüfvorrichtung zur Erfassung und Lokalisierung von Materialinhomogenitäten in elektrisch leitenden Proben (10), aufweisend einen Halter (30) für die zu prüfende Probe (10), eine Temperatureinstelleinrichtung (30, 50, 60) zur Ausbildung eines Temperaturprofils in der Probe (10), und zumindest einen Meßwertaufnehmer (20) zur kontaktlosen Messung des Magnetfelds außerhalb der Probe (10), **dadurch gekennzeichnet, daß** mehrere Meßwertaufnehmer in unterschiedlichem Abstand von der Probe (10) vorgesehen sind.

2. Prüfvorrichtung nach Anspruch 1, **dadurch gekennzeichnet, daß** der Halter (30) mit einem Drehantrieb zur Drehung der Probe (10) verbunden ist.

3. Prüfvorrichtung nach einem der vorhergehenden Ansprüche, **dadurch gekennzeichnet, daß** die Meßwertaufnehmer einen Squid-Sensor aufweisen.

4. Prüfvorrichtung nach Anspruch 3, **dadurch gekennzeichnet, daß** der Squid-Sensor ein Squid-Magnetometer aufweist.

5. Prüfvorrichtung nach Anspruch 3, **dadurch gekennzeichnet, daß** der Squid-Sensor ein Squid-Gradiometer aufweist.

6. Verfahren zur Erfassung und Lokalisierung von Materialinhomogenitäten in elektrisch leitenden Proben, wobei die Probe auf ein vorbestimmtes Temperaturprofil gebracht wird und das Magnetfeld außerhalb der Probe (10) kontaktlos gemessen wird, **dadurch gekennzeichnet, daß** das Magnetfeld außerhalb der Probe mit mehreren Meßwertaufnehmern gemessen wird, die in unterschiedlichem Abstand von der Probe vorgesehen sind.

7. Verfahren nach Anspruch 6, **dadurch gekennzeichnet, daß** die Probe gedreht wird.

8. Verfahren nach einem der Ansprüche 6 oder 7, **dadurch gekennzeichnet, daß** aus der Polarität des Meßsignals und der Richtung des Temperaturgradienten auf den Typ der Inhomogenität geschlossen wird.

9. Verfahren nach einem der Ansprüche 6 bis 8, **dadurch gekennzeichnet, daß** zur verbesserten Lokalisierung und Formbestimmung der Inhomogenität das Temperaturprofil in der Probe (10) in nacheinander folgenden Messungen unterschiedlich eingestellt wird.

10. Verfahren nach Anspruch 6, **dadurch gekennzeichnet, daß** in nacheinander folgenden Messungen das Magnetfeld in unterschiedlichen Entfernungen von der Probe (10) gemessen wird.

11. Verfahren nach Anspruch 6, **dadurch gekennzeichnet, daß** mit den mehreren Meßwertaufnehmern gleichzeitig gemessen wird.

## Claims

1. Testing device for detecting and localising material inhomogeneities in electrically conductive samples (10) comprising a holder (30) for the sample (10) to be tested, a temperature setting device (30, 50, 60) for forming a temperature profile in the sample (10), and at least one measuring sensor (20) for contactless measurement of the magnetic field outside the sample (10), **characterised in that** several measuring sensors are provided at different distances to the sample (10).

2. Testing device according to claim 1, **characterised in that** the holder (30) is connected to a rotational drive for rotating the sample (10).

3. Testing device according to one of the preceeding claims, **characterised in that** the measuring sensors comprise a Squid sensor.

4. Testing device according to claim 3, **characterised in that** the Squid sensor is a Squid magnetometer.

5. Testing device according to claim 3, **characterised in that** the Squid sensor comprises a Squid gradiometer.

6. Method of detecting and localising material inhomogeneities in electrically conductive samples, wherein the sample is brought to a predetermined temperature profile and the magnetic field outside the sample (10) is contactlessly measured, **characterised in that** the magnetic field outside the sample is measured with several measuring sensors, which are provided at different distances to the sample.

7. Method according to claim 6, **characterised in that** the sample is rotated.

8. Method according to one of the claims 6 or 7, **characterised in that** from the polarity of the measuring signal and the direction of the temperature gradient one may infer the type of homogeneity.

9. Method according to one of the claims 6 to 8, **characterised in that** for the improved localisation and shape determination of the inhomogeneity the temperature profile in the sample (10) is differently set in subsequent measurements.

10. Method according to claim 6, **characterised in that** in subsequent measurements the magnetic field is measured at different distances to the sample.

11. Method according to claim 6, **characterised in that** it is simultaneously measured with several measuring sensors.

## Revendications

1. Dispositif d'essai pour détecter et localiser des hétérogénéités de matériaux dans des échantillons conducteurs électriques (10), ledit dispositif comprenant un support (30) pour les échantillons à examiner (10), un dispositif d'ajustement de la température (30, 50, 60) pour former un profil de température dans l'échantillon (10), et au moins un détecteur (20) pour mesurer, sans contact, le champ magnétique en dehors de l'échantillon (10), **caractérisé en ce que** plusieurs détecteurs sont fournis à des distances variées de l'échantillon (10).

2. Dispositif d'essai selon la revendication 1, **caractérisé en ce que** le support (30) est lié à un entraîneur rotatif pour la rotation de l'échantillon (10).

3. Dispositif d'essai selon l'une des revendications précédentes, **caractérisé en ce que** le détecteur comprend un capteur squid.

4. Dispositif d'essai selon la revendication 3, **caractérisé en ce que** le capteur squid comprend un magnétomètre squid.

5. Dispositif d'essai selon la revendication 3, **caractérisé en ce que** le capteur squid comprend un gradiomètre squid.

6. Procédé pour détecter et localiser des hétérogénéités de matériaux dans des échantillons conducteurs électriques, sachant que l'échantillon est porté à un certain profil de température prédéterminé et que le champ magnétique en dehors de l'échantillon (10) est mesuré sans contact, **caractérisé en ce que** le champ magnétique en dehors de l'échantillon est mesuré à l'aide de plusieurs détecteurs qui sont fournis à des distances variées de l'échantillon.

7. Procédé selon la revendication 6, **caractérisé en ce qu'**on fait tourner l'échantillon.

8. Procédé selon l'une des revendications 6 ou 7, **caractérisé en ce que** le type d'hétérogénéité est déduit de la polarité du signal mesuré et de la direction du gradient de température.

9. Procédé selon l'une des revendications 6 à 8, **caractérisé en ce que** pour mieux localiser et mieux déterminer la forme de l'hétérogénéité, le profil de température dans l'échantillon (10) est modifié au cours des mesures successives.

10. Procédé selon la revendication 6, **caractérisé en ce qu'**au cours des mesures successives, le champ magnétique est mesuré à des distances variées de l'échantillon (10).

11. Procédé selon la revendication 6, **caractérisé en ce que** des mesures sont effectuées simultanément avec les différents détecteurs.
